# EUROPEAN PATENT APPLICATION

(11) **EP 4 738 634 A1**
(43) Date of publication of application: **06.05.2026**
(21) Application number: 25212876.4
(22) Date of filing: 02.11.2025
(51) Int. Cl.: H02G 5/10

(54) **POWER DELIVERY MODULE**

(30) Priority: 04.11.2024 US 202463715650 P; 24.01.2025 US 202563748998 P; 27.10.2025 US 202519369378
(71) Applicant: CYNTEC CO., LTD., Hsinchu 30076 (TW)
(72) Inventor: Hu, Chih-Yu, 30076 Hsinchu (TW); Chuang, Wen-Ching, 30076 Hsinchu (TW); Ho, Yu-Hsien, 30076 Hsinchu (TW); Fang, Yu-Ching, 30076 Hsinchu (TW); Lee, Li-Chuang, 30076 Hsinchu (TW); Faulstich, Rene, 30076 Hsinchu (TW)
(74) Representative: Straus, Alexander

(57) **Abstract**

A heat dissipation structure (18, 18a, 18b) is disposed between two busbars (12, 14) or disposed outside the busbar (12, 14), so as to dissipate heat from the busbar (12, 14). In an embodiment, the heat dissipation structure (18) is disposed between two busbars (12, 14), such that a single heat dissipation structure (18) is used to dissipate heat from two busbars (12, 14) simultaneously, so as to reduce cost of the heat dissipation structure (18). Furthermore, an insulation member (20, 21, 22, 24, 26) is disposed between the two busbars (12, 14) and/or disposed between the busbar (12, 14) and the heat dissipation structure (18, 18a, 18b) to achieve electrical insulation.

## Description

### Field of the Invention

The present invention relates to a power delivery module, particularly a power delivery module capable of improving heat dissipation efficiency and reducing heat dissipation cost for a busbar.

### Background of the Invention

With the rise of big data, machine learning, the Internet of Things, and various network platforms, the demand for servers in life is getting higher and higher. In general, the server is connected to a busbar behind a rack for power supply. The busbar will generate a lot of heat during operation. Therefore, how to effectively improve heat dissipation efficiency and reduce heat dissipation cost for the busbar has become a significant design issue.

### Summary of the Invention

The present invention aims at providing a power delivery module capable of improving heat dissipation efficiency and reducing heat dissipation cost for a busbar, thereby resolving the aforesaid problems.

This is achieved by a power delivery module according to claim 1. The dependent claims pertain to corresponding further developments and improvements.

As will be seen more clearly from the detailed description following below, the claimed power delivery module includes a first busbar, a second busbar, a heat dissipation structure, a first insulation member and a second insulation member. The second busbar is disposed opposite to the first busbar. The heat dissipation structure is disposed between the first busbar and the second busbar. The first insulation member is disposed between the first busbar and the heat dissipation structure. The second insulation member is disposed between the first busbar and the second busbar. A thickness of the first insulation member is greater than or equal to a thickness of the second insulation member.

In an embodiment, the first insulation member is formed in a single ring-shaped structure surrounding the heat dissipation structure, such that the first insulation member is also disposed between the second busbar and the heat dissipation structure.

In an embodiment, a thermal conductivity of the first insulation member is greater than a thermal conductivity of the second insulation member.

In an embodiment, a material of the first insulation member is different from a material of the second insulation member.

In an embodiment, a resistivity of the second insulation member is greater than a resistivity of the first insulation member.

In an embodiment, the first insulation member partially overlaps with the second insulation member.

In an embodiment, the heat dissipation structure includes a pipe formed with a plurality of fins therein.

In an embodiment, the heat dissipation structure includes a pipe and a plurality of sub-tubes disposed in the pipe.

In an embodiment, the heat dissipation structure includes a pipe and two thermal conductive blocks, and the pipe is sandwiched between the two thermal conductive blocks.

In an embodiment, the pipe is accommodated in a space formed between the two thermal conductive blocks, and a thermal interface material is filled in the space.

In an embodiment, the heat dissipation structure includes a pipe and a thermal conductive plate, and the pipe is embedded into the thermal conductive plate and exposed from a side of the thermal conductive plate.

In an embodiment, the heat dissipation structure includes a pipe and at least one corrugated plate disposed in the pipe.

In an embodiment, the heat dissipation structure includes a plurality of corrugated plates arranged in the pipe at intervals.

In an embodiment, the heat dissipation structure includes a plurality of corrugated plates, and two corrugated structures of two adjacent corrugated plates are arranged in a staggered manner.

In an embodiment, an inner wall of the pipe is formed with at least one longitudinal groove, and the at least one corrugated plate has at least one engaging portion engaged with the at least one longitudinal groove.

In an embodiment, the first busbar and the second busbar have two recesses opposite to each other, and the heat dissipation structure is accommodated in the two recesses.

In an embodiment, the power delivery module further includes a third insulation member and a fourth insulation member. The third insulation member is disposed between the second busbar and the heat dissipation structure. The fourth insulation member is disposed between the first busbar and the second busbar. The second insulation member and the fourth insulation member are located at opposite sides of the heat dissipation structure.

### Brief Description of the Drawings

In the following, the invention is further illustrated by way of example, taking reference to the accompanying drawings thereof:
FIG. 1 is a perspective view illustrating a power delivery module according to an embodiment of the invention,
FIG. 2 is a sectional view illustrating the power delivery module shown in FIG. 1,
FIG. 3 is a sectional view illustrating the power delivery module according to another embodiment,
FIG. 4 is a perspective view illustrating the heat dissipation structure according to another embodiment of the invention,
FIG. 5 is a front view illustrating the heat dissipation structure shown in FIG. 4,
FIG. 6 is a perspective view illustrating the heat dissipation structure according to another embodiment of the invention,
FIG. 7 is a front view illustrating the heat dissipation structure shown in FIG. 6,
FIG. 8 is a side view illustrating the heat dissipation structure according to another embodiment of the invention,
FIG. 9 is a perspective view illustrating the heat dissipation structure according to another embodiment of the invention,
FIG. 10 is a sectional view illustrating the power delivery module according to another embodiment of the invention,
FIG. 11 is a sectional view illustrating the power delivery module according to another embodiment of the invention, and
FIG. 12 is a sectional view illustrating a power delivery module according to another embodiment of the invention.

### Detailed Description

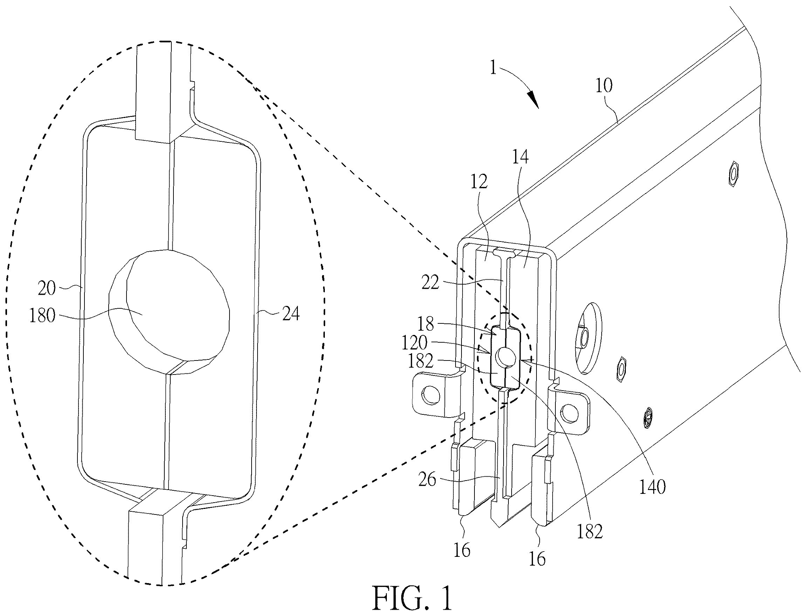

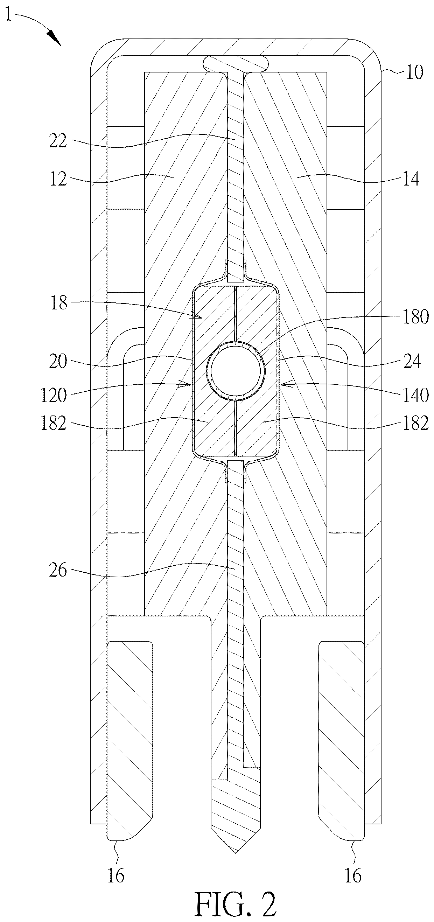

Referring to FIGs. 1 and 2, FIG. 1 is a perspective view illustrating a power delivery module 1 according to an embodiment of the invention, and FIG. 2 is a sectional view illustrating the power delivery module 1 shown in FIG. 1.

As shown in FIGs. 1 and 2, the power delivery module 1 comprises a housing 10, a first busbar 12, a second busbar 14, two ground busbars 16, a heat dissipation structure 18, a first insulation member 20, a second insulation member 22, a third insulation member 24 and a fourth insulation member 26. In practical applications, the power delivery module 1 may be connected to an electronic device (e.g. server) for power supply.

The first busbar 12 and the second busbar 14 are disposed in the housing 10, wherein the second busbar 14 is disposed opposite to the first busbar 12. The material of the first busbar 12 and the second busbar 14 may be copper or copper with nickel silver coating. In some embodiments, the material of the first busbar 12 and the second busbar 14 may be aluminum. In practical applications, one of the first busbar 12 and the second busbar 14 may be a positive busbar, and the other one of the first busbar 12 and the second busbar 14 may be a negative busbar. The two ground busbars 16 are fixed to two inner walls of the housing 10 and located at opposite sides of the first busbar 12 and the second busbar 14. The first busbar 12, the second busbar 14 and the two ground busbars 16 may be fixed to the housing 10 by bolts or the like.

The heat dissipation structure 18 is disposed between the first busbar 12 and the second busbar 14. In this embodiment, the heat dissipation structure 18 may comprise a pipe 180 and two thermal conductive blocks 182. A cooling liquid (e.g. water) may flow through the pipe 180 to perform liquid cooling effect. The pipe 180 may be circular and sandwiched between the two thermal conductive blocks 182 to simplify the manufacturing process. However, hollow pipe fittings of various shapes may be used for fluid circulation. Thus, the pipe 180 is not limited to circular and the shape of the pipe 180 may be determined according to practical applications. It should be noted that the pipe 180 may have a liquid inlet and a liquid outlet exposed from at least one side of the housing 10, and the end of the pipe 180 shown in FIG. 1 is a closed end. Furthermore, the pipe 180 may have internal structures such as grids, fine structures (e.g. gears) or capillary structures on the inner surface, so as to improve heat dissipation efficiency. The material of the two thermal conductive blocks 182 may be aluminum and the material of the pipe 180 may be copper, but the invention is not so limited. Still further, the first busbar 12 and the second busbar 14 may have two recesses 120, 140 opposite to each other, and the heat dissipation structure 18 may be accommodated in the two recesses 120, 140, so as to reduce the overall thickness.

The first insulation member 20 is disposed between the first busbar 12 and the heat dissipation structure 18, and the third insulation member 24 is disposed between the second busbar 14 and the heat dissipation structure 18. The materials of the first insulation member 20 and the third insulation member 24 may be polyimide (PI), thermal tape, epoxy, etc., and it depends on practical applications. The second insulation member 22 is disposed between the first busbar 12 and the second busbar 14, and the fourth insulation member 26 is also disposed between the first busbar 12 and the second busbar 14, wherein the second insulation member 22 and the fourth insulation member 26 are located at opposite sides of the heat dissipation structure 18. The materials of the second insulation member 22 and the fourth insulation member 26 may be plastic material, such as polypropylene (PP), polyphthalamide (PPA), polyphenylene sulfide (PPS), polyamide (PA), acrylonitrile butadiene styrene (ABS), polyketone (PK), polycarbonate (PC), polybutylene terephthalate (PBT), liquid crystal polymer (LCP), etc., and it depends on practical applications. The plastic material may also be filled with 10-40 wt% glass fiber. Thus, a material of each of the first insulation member 20 and the third insulation member 24 is different from a material of each of the second insulation member 22 and the fourth insulation member 26.

The first insulation member 20, the second insulation member 22, the third insulation member 24 and the fourth insulation member 26 are configured to insulate the power supply voltage between the first busbar 12 and the second busbar 14, wherein the power supply voltage may be between 0 V and 800 V. In this embodiment, a thickness of each of the first insulation member 20 and the third insulation member 24 is greater than or equal to a thickness of each of the second insulation member 22 and the fourth insulation member 26. For example, the thickness of each of the first insulation member 20 and the third insulation member 24 may be 2 mm, and the thickness of each of the second insulation member 22 and the fourth insulation member 26 may be between 0.02 mm and 2 mm, but the invention is not so limited. Furthermore, a thermal conductivity of each of the first insulation member 20 and the third insulation member 24 is greater than a thermal conductivity of each of the second insulation member 22 and the fourth insulation member 26. For example, the thermal conductivity of each of the first insulation member 20 and the third insulation member 24 may be between 2 W/m-k and 3.5 W/m-k, and the thermal conductivity of each of the second insulation member 22 and the fourth insulation member 26 may be between 0.25 W/m-k and 0.36 W/m-k, but the invention is not so limited. Still further, a resistivity of each of the second insulation member 22 and the fourth insulation member 26 is greater than a resistivity of each of the first insulation member 20 and the third insulation member 24. Moreover, an insulation coefficient of each of the first insulation member 20 and the third insulation member 24 may be between 20 KV/mm and 50 KV/mm, and an insulation coefficient of each of the second insulation member 22 and the fourth insulation member 26 may be between 10 KV/mm and 50 KV/mm, but the invention is not so limited. Therefore, the first insulation member 20 and the third insulation member 24 have better thermal conductivity than the second insulation member 22 and the fourth insulation member 26, and the second insulation member 22 and the fourth insulation member 26 have better insulation and heat resistance than the first insulation member 20 and the third insulation member 24.

In this embodiment, opposite ends of the first insulation member 20 may partially overlap with the second insulation member 22 and the fourth insulation member 26 respectively, so as to ensure the insulation effect between the first busbar 12 and the heat dissipation structure 18. Similarly, opposite ends of the third insulation member 24 may also overlap with the second insulation member 22 and the fourth insulation member 26 respectively, so as to ensure the insulation effect between the second busbar 14 and the heat dissipation structure 18.

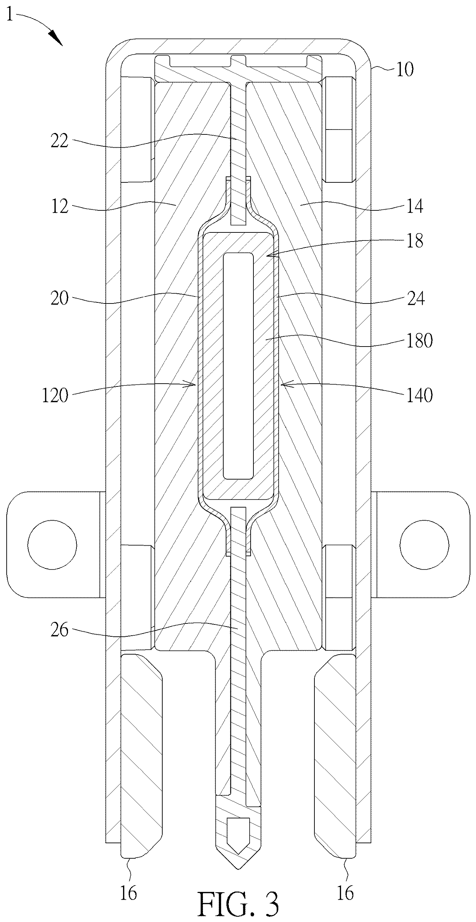

Referring to FIG. 3, FIG. 3 is a sectional view illustrating the power delivery module 1 according to another embodiment of the invention.

As shown in FIG. 3, the heat dissipation structure 18 of the power delivery module 1 may comprise a pipe 180 only and the aforesaid thermal conductive blocks 182 may be omitted. In this embodiment, the pipe 180 may be rectangular, but the invention is not so limited. In another embodiment, the pipe 180 may be circular or other shapes according to practical applications. Since the pipe 180 is in direct contact with the first insulation member 20 and the third insulation member 24, the heat generated by the first busbar 12 and the second busbar 14 may be conducted to the pipe 180 directly, so as to improve heat dissipation efficiency.

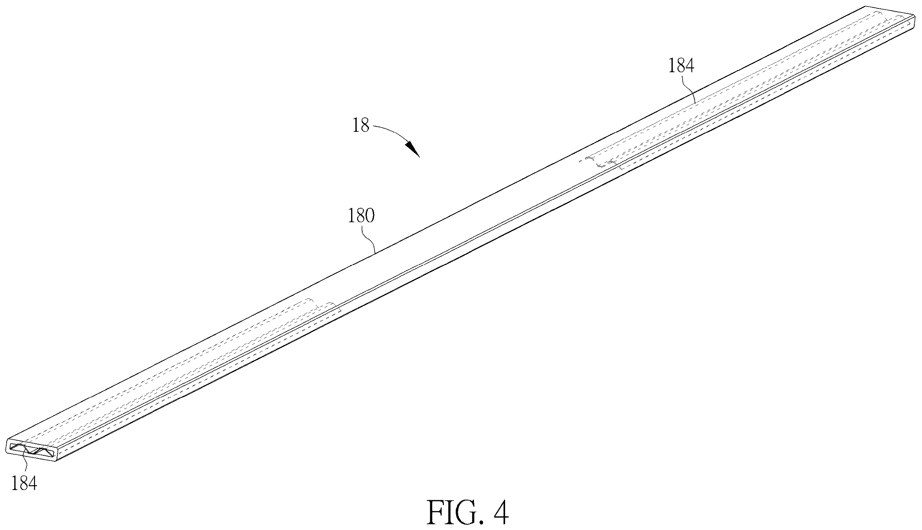

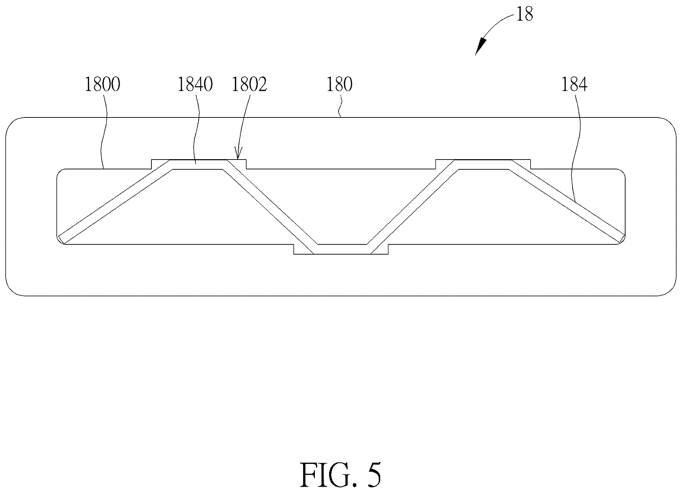

Referring to FIGs. 4 and 5, FIG. 4 is a perspective view illustrating the heat dissipation structure 18 according to another embodiment of the invention, and FIG. 5 is a front view illustrating the heat dissipation structure 18 shown in FIG. 4.

As shown in FIGs. 4 and 5, the heat dissipation structure 18 may comprises a pipe 180 and at least one corrugated plate 184 disposed in the pipe 180. In this embodiment, the heat dissipation structure 18 may comprise a plurality of corrugated plates 184 arranged in the pipe 180 at intervals. For example, as shown in FIG. 4, the heat dissipation structure 18 may comprise two corrugated plates 184 arranged in the pipe 180 at intervals, such that a region without corrugated plate is located between the two corrugated plates 184. It should be noted that the number of corrugated plates 184 may be determined according to practical applications, so the invention is not limited to the embodiment shown in the figure. For example, the number of corrugated plates 184 may be one that is the same length as the pipe 180, or several that are separated throughout the pipe 180. The materials of the pipe 180 and the corrugated plates 184 may be copper, aluminum or other metals. The pipe 180 and the corrugated plates 184 may be assembled by welding, adhesive, engagement, or other fixing manners. The shape of the corrugated plate 184 may be, but is not limited to, serrated, and the number of waves (folds) may be one or more.

The corrugated plates 184 are configured to divide the inner space of the pipe 180 into a plurality of liquid channels. Thus, when a cooling liquid flows through the liquid channels, turbulence will be generated to remove more heat, such that the cost of the heat dissipation structure 18 will be reduced under the same or even higher contact area and the heat dissipation efficiency will be improved.

As shown in FIG. 5, an inner wall 1800 of the pipe 180 may be formed with at least one longitudinal groove 1802, and the at least one corrugated plate 184 has at least one engaging portion 1840 engaged with the at least one longitudinal groove 1802. In this embodiment, the inner wall 1800 of the pipe 180 may be formed with three longitudinal grooves 1802 on opposite sides, and the corrugated plate 184 may have three engaging portions 1840 engaged with the three longitudinal grooves 1802. The corrugated plate 184 may slide into the pipe 180 by aligning the engaging portions 1840 with the longitudinal grooves 1802, such that the corrugated plate 184 is positioned and fixed in the pipe 180 through the engagement between the engaging portions 1840 and the longitudinal grooves 1802.

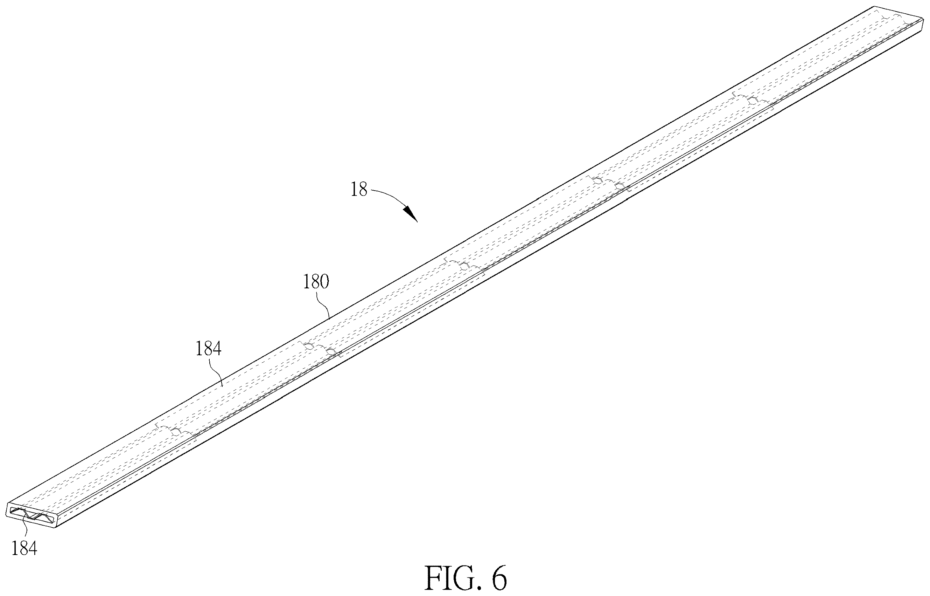

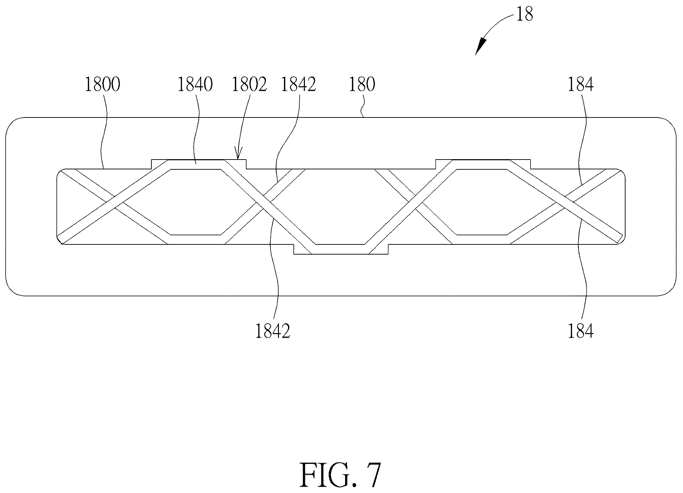

Referring to FIGs. 6 and 7, FIG. 6 is a perspective view illustrating the heat dissipation structure 18 according to another embodiment of the invention, and FIG. 7 is a front view illustrating the heat dissipation structure 18 shown in FIG. 6.

As shown in FIGs. 6 and 7, the heat dissipation structure 18 may comprise a plurality of corrugated plates 184, and two corrugated structures 1842 of two adjacent corrugated plates 184 may be arranged in a staggered manner. When a cooling liquid flows through the staggered interface between two adjacent corrugated plates 184, turbulence will be generated to remove more heat, such that the cost of the heat dissipation structure 18 will be reduced under the same or even higher contact area and the heat dissipation efficiency will be improved.

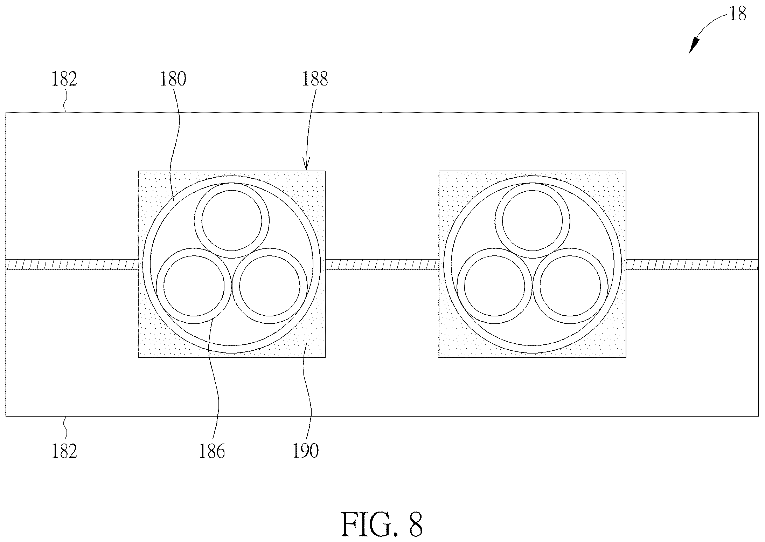

Referring to FIG. 8, FIG. 8 is a side view illustrating the heat dissipation structure 18 according to another embodiment of the invention.

As shown in FIG. 8, the heat dissipation structure 18 may comprise a pipe 180, two thermal conductive blocks 182 and a plurality of sub-tubes 186. The sub-tubes 186 are disposed in the pipe 180. The pipe 180 is accommodated in a space 188 formed between the two thermal conductive blocks 182. In this embodiment, the space 188 formed between the two thermal conductive blocks 182 may be, but is not limited to, rectangular. Furthermore, a thermal interface material (TIM) 190 is filled in the space 188. Through the arrangement of the heat dissipation structure 18 shown in FIG. 8, the heat dissipation efficiency will be improved.

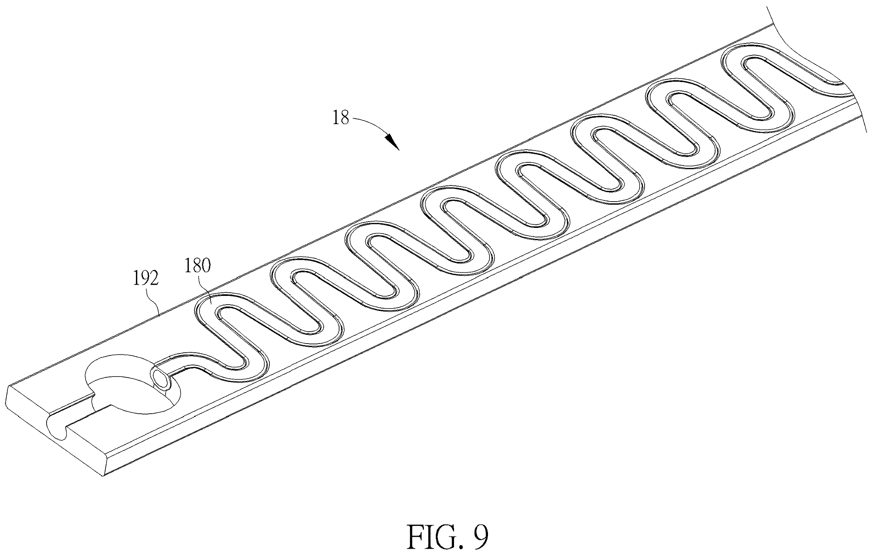

Referring to FIG. 9, FIG. 9 is a perspective view illustrating the heat dissipation structure 18 according to another embodiment of the invention.

As shown in FIG. 9, the heat dissipation structure 18 may comprise a pipe 180 and a thermal conductive plate 192. In this embodiment, the pipe 180 may be embedded into the thermal conductive plate 192 and exposed from a side of the thermal conductive plate 192.

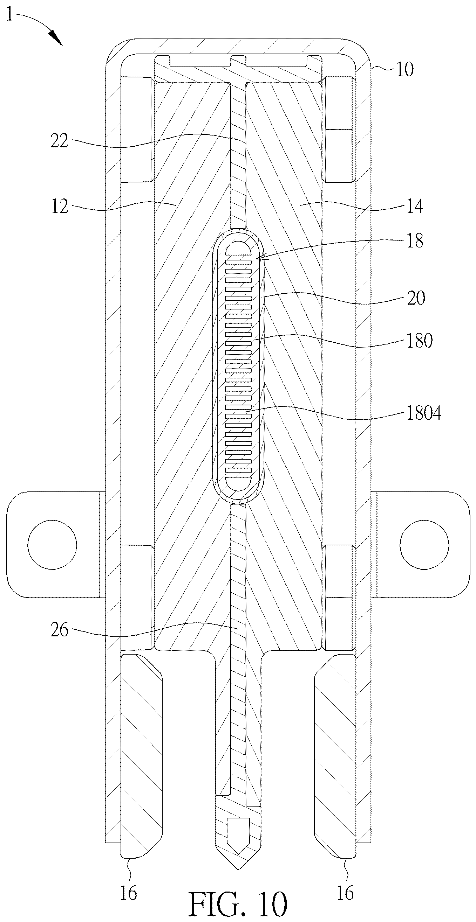

Referring to FIG. 10, FIG. 10 is a sectional view illustrating the power delivery module 1 according to another embodiment of the invention.

As shown in FIG. 10, the first insulation member 20 may be formed in a single ring-shaped structure surrounding the heat dissipation structure 18, such that the first insulation member 20 is also disposed between the second busbar 14 and the heat dissipation structure 18. Thus, the third insulation member 24 shown in FIGs. 2 and 3 may be omitted. Furthermore, the heat dissipation structure 18 may comprise a pipe 180 only and the pipe 180 may be formed with a plurality of fins 1804 therein. The fins 1804 are configured to improve the heat dissipation efficiency. In this embodiment, the pipe 180 may be, but is not limited to, a closed oval pipe. In another embodiment, the pipe 180 may be square, rectangular, trapezoid or other shapes according to practical applications. Moreover, the material of the fins 1804 may be copper, aluminum, or copper/aluminum covered with insulating plastic.

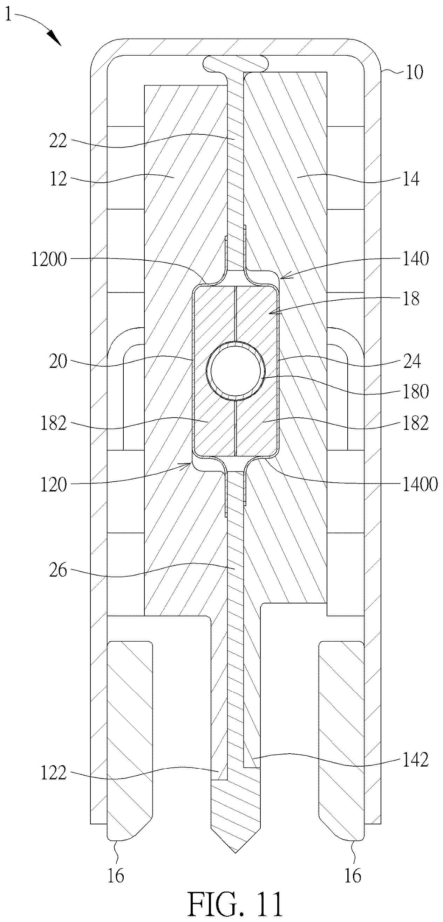

Referring to FIG. 11, FIG. 11 is a sectional view illustrating the power delivery module 1 according to another embodiment of the invention.

As shown in FIG. 11, the first busbar 12 and the second busbar 14 may be in identical shape. In this embodiment, two ends 122, 142 of the first busbar 12 and the second busbar 14 are misaligned in an insertion opening 100 of the housing 10, such that the two recesses 120, 140 are misaligned and the heat dissipation structure 18 abuts against two edges 1200, 1400 of the two recesses 120, 140 diagonal to each other. Since the first busbar 12 and the second busbar 14 are in identical shape, the first busbar 12 and the second busbar 14 may be manufactured by a single mold, so as to reduce the manufacturing cost.

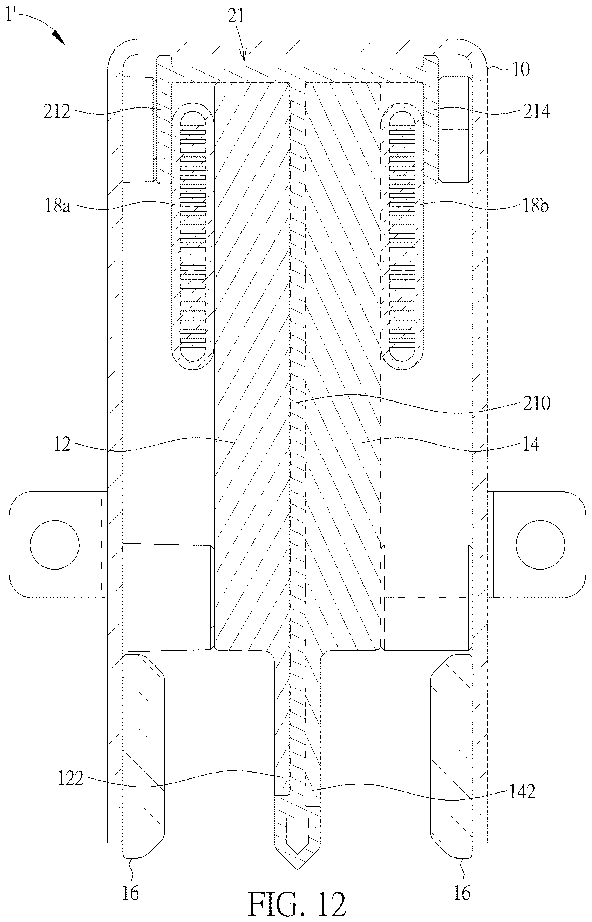

Referring to FIG. 12, FIG. 12 is a sectional view illustrating a power delivery module 1' according to another embodiment of the invention.

As shown in FIG. 12, the power delivery module 1' comprises a housing 10, a first busbar 12, a second busbar 14, two ground busbars 16, a first heat dissipation structure 18a, a second heat dissipation structure 18b and an insulation member 21. In practical applications, the power delivery module 1' may be connected to an electronic device (e.g. server) for power supply.

The first busbar 12 and the second busbar 14 are disposed in the housing 10, wherein the second busbar 14 is disposed opposite to the first busbar 12. The first busbar 12 and the second busbar 14 may be copper or copper with nickel silver coating. In some embodiments, the first busbar 12 and the second busbar 14 may be aluminum. In practical applications, one of the first busbar 12 and the second busbar 14 may be a positive busbar, and the other one of the first busbar 12 and the second busbar 14 may be a negative busbar. The two ground busbars 16 are fixed to two inner walls of the housing 10 and located at opposite sides of the first busbar 12 and the second busbar 14. The first busbar 12, the second busbar 14 and the two ground busbars 16 may be fixed to the housing 10 by bolts or the like.

The first heat dissipation structure 18a is disposed outside the first busbar 12 and the second heat dissipation structure 18b is disposed outside the second busbar 14. In this embodiment, the first heat dissipation structure 18a and the second heat dissipation structure 18b may be designed as any of the heat dissipation structures 18 shown in FIGs. 1 to 10 according to practical applications, and the related explanation will not be depicted again herein.

The insulation member 21 comprises a central portion 210, a first clamping portion 212 and a second clamping portion 214, wherein the central portion 210 is connected between the first clamping portion 212 and the second clamping portion 214. The central portion 210 is sandwiched between the first busbar 12 and the second busbar 14, and two ends 122, 142 of the first busbar 12 and the second busbar 14 are misaligned in an insertion opening 100 of the housing 10. The first clamping portion 212 clamps the first heat dissipation structure 18a with the first busbar 12. The second clamping portion 214 clamps the second heat dissipation structure 18b with the second busbar 14. Accordingly, the power supply voltage between the first busbar 12 and the second busbar 14 is insulated by the central portion 210 of the insulation member 21, and the first heat dissipation structure 18a and the second heat dissipation structure 18b are respectively fixed outside the first busbar 12 and the second busbar 14 by the first clamping portion 212 and the second clamping portion 214 of the insulation member 21. The material of the insulation member 21 may be plastic material, such as polypropylene (PP), polyphthalamide (PPA), polyphenylene sulfide (PPS), polyamide (PA), acrylonitrile butadiene styrene (ABS), polyketone (PK), polycarbonate (PC), polybutylene terephthalate (PBT), liquid crystal polymer (LCP), etc., and it depends on practical applications. The plastic material may also be filled with 10-40 wt% glass fiber.

As mentioned in the above, the invention may dispose the heat dissipation structure between two busbars or dispose the heat dissipation structure outside the busbar, so as to dissipate heat from the busbar. In an embodiment, the heat dissipation structure is disposed between two busbars, such that the invention can use a single heat dissipation structure to dissipate heat from two busbars simultaneously, so as to reduce cost of the heat dissipation structure. Furthermore, the invention may dispose the insulation member between the two busbars and/or dispose the insulation member between the busbar and the heat dissipation structure to achieve electrical insulation.

## Claims

1. A power delivery module (1) comprising:
a first busbar (12);
a second busbar (14) being disposed opposite to the first busbar (12);
**characterized by** the power delivery module (1) further comprising:
a heat dissipation structure (18) being disposed between the first busbar (12) and the second busbar (14);
a first insulation member (20) being disposed between the first busbar (12) and the heat dissipation structure (18); and
a second insulation member (22) being disposed between the first busbar (12) and the second busbar (14);
wherein a thickness of the first insulation member (20) is greater than or equal to a thickness of the second insulation member (22).

2. The power delivery module (1) of claim 1 further **characterized in that** the first insulation member (20) is formed in a single ring-shaped structure surrounding the heat dissipation structure (18), such that the first insulation member (20) is also disposed between the second busbar (14) and the heat dissipation structure (18).

3. The power delivery module (1) of claim 1 further **characterized in that** a thermal conductivity of the first insulation member (20) is greater than a thermal conductivity of the second insulation member (22).

4. The power delivery module (1) of claim 1 further **characterized in that** a material of the first insulation member (20) is different from a material of the second insulation member (22).

5. The power delivery module (1) of claim 1 further **characterized in that** a resistivity of the second insulation member (22) is greater than a resistivity of the first insulation member (20).

6. The power delivery module (1) of claim 1 further **characterized in that** the first insulation member (20) partially overlaps with the second insulation member (22).

7. The power delivery module (1) of claim 1 further **characterized in that** the heat dissipation structure (18) comprises a pipe (180) formed with a plurality of fins (1804) therein.

8. The power delivery module (1) of claim 1 further **characterized in that** the heat dissipation structure (18) comprises a pipe (180) and a plurality of sub-tubes (186) disposed in the pipe (180).

9. The power delivery module (1) of claim 1 further **characterized in that** the heat dissipation structure (18) comprises a pipe (180) and two thermal conductive blocks (182), and the pipe (180) is sandwiched between the two thermal conductive blocks (182).

10. The power delivery module (1) of claim 9 further **characterized in that** the pipe (180) is accommodated in a space (188) formed between the two thermal conductive blocks (182), and a thermal interface material (190) is filled in the space (188).

11. The power delivery module (1) of claim 1 further **characterized in that** the heat dissipation structure (18) comprises a pipe (180) and a thermal conductive plate (192), and the pipe (180) is embedded into the thermal conductive plate (192) and exposed from a side of the thermal conductive plate (192).

12. The power delivery module (1) of claim 1 further **characterized in that** the heat dissipation structure (18) comprises a pipe (180) and at least one corrugated plate (184) disposed in the pipe (180).

13. The power delivery module (1) of claim 12 further **characterized in that** the heat dissipation structure (18) comprises a plurality of corrugated plates (184) arranged in the pipe (180) at intervals.

14. The power delivery module (1) of claim 12 further **characterized in that** the heat dissipation structure (18) comprises a plurality of corrugated plates (184), and two corrugated structures (1842) of two adjacent corrugated plates (184) are arranged in a staggered manner.

15. The power delivery module (1) of claim 12 further **characterized in that** an inner wall (1800) of the pipe (180) is formed with at least one longitudinal groove (1802), and the at least one corrugated plate (184) has at least one engaging portion (1840) engaged with the at least one longitudinal groove (1802).

16. The power delivery module (1) of claim 1 further **characterized in that** the first busbar (12) and the second busbar (14) have two recesses (120, 140) opposite to each other, and the heat dissipation structure (18) is accommodated in the two recesses (120, 140).

17. The power delivery module (1) of claim 1 further **characterized in that** the power delivery module (1) further comprises:
a third insulation member (24) being disposed between the second busbar (14) and the heat dissipation structure (18); and
a fourth insulation member (26) being disposed between the first busbar (12) and the second busbar (14), the second insulation member (22) and the fourth insulation member (26) being located at opposite sides of the heat dissipation structure (18).
